# EUROPEAN PATENT SPECIFICATION

(11) **EP 4 386 913 B1**
(45) Date of publication and mention of the grant of the patent: **03.06.2026**
(21) Application number: 23194561.9
(22) Date of filing: 31.08.2023
(51) Int. Cl.: H01M 8/04858, H01M 8/04537, H01M 8/04664, H01M 8/10

(54) **FUEL CELL SYSTEM AND AIR BLEEDING METHOD THEREOF**
BRENNSTOFFZELLENSYSTEM UND ENTLÜFTUNGSVERFAHREN DAFÜR
SYSTÈME DE PILE À COMBUSTIBLE ET SON PROCÉDÉ DE PURGE D'AIR

(30) Priority: 12.12.2022 KR 20220172822
(43) Date of publication of application: 19.06.2024
(73) Proprietor: Hyundai Motor Company, Seoul 06797 (KR); Kia Corporation, Seocho-gu Seoul 06797 (KR)
(72) Inventor: LEE, Yong Hee, 16891 Yongin-si, Gyeonggi-do (KR)
(74) Representative: Viering, Jentschura & Partner mbB Patent- und Rechtsanwälte

(56) References cited:
- US-A1- 2016 242 326
- US-A1- 2022 367 888
- US-A1- 2022 376 277

## Description

### CROSS-REFERENCE TO RELATED APPLICATION

This application claims the benefit under of Korean Patent Application No. 10-2022-0172822, filed in the Korean Intellectual Property Office on December 12, 2022.

### BACKGROUND

### 1. Field

The present disclosure relates to a fuel cell system and an air bleeding method thereof.

### 2. Description of the Related Art

A fuel cell system may generate electrical energy using a fuel cell stack. For example, hydrogen, which is used as a fuel for the fuel cell stack, may be an alternative to solving the global environmental problem. Accordingly, continuous research and development on fuel cell systems is being conducted.

The fuel cell system includes a fuel cell stack which generates electrical energy, a fuel supply which supplies fuel (hydrogen) to the fuel cell stack, an air supply which supplies oxygen in the air serving as an oxidant necessary for electrochemical reactions, and a thermal management system (TMS) which removes reaction heat from the fuel cell stack to discharge the reaction heat to the outside, controls an operating temperature of the fuel cell stack, and performs a water managing function..

The TMS is a type of cooling device which circulates antifreeze, which serves as a coolant, to the fuel cell stack to maintain an appropriate temperature (e.g., 60 °C to 70 °C). The TMS may include a TMS line for circulating the coolant, a pump to circulate the coolant, an ion filter to remove ions, which are contained in the coolant, and a radiator to discharge heat from the coolant to the outside.

In addition, the TMS may maintain the appropriate temperature by circulating the coolant to electronic parts of a vehicle as well as the fuel cell stack. Electronic part cooling lines to circulate the coolant to electronic parts may include a radiator for the electronic radiator, a coolant pump for the electronic radiator, and a reservoir tank for the electronic part.

When electronic parts are replaced or coolant leaks, a new coolant is injected into the cooling line for the electronic part. In this process, air bubbles may be generated in the coolant flowing through the cooling line for the electronic part. As described above, when the air bubbles are generated in the coolant, the cooling performance in the cooling line (electronic part cooling line) for the electronic part may be degraded, and an erroneous operation may be caused in a pump motor for the coolant.

To this end, an electronic water pump (EWP) is installed on the electronic part cooling line of the fuel cell system for the vehicle to perform air bleeding to remove air bubbles from the coolant. However, there is no separate electronic water pump in the electronic part cooling line of the fuel cell system applied to a smaller moving body, which is not a vehicle. Accordingly, it is unnecessary to perform a work of removing air from the coolant. In addition, a problem caused by the air bubbles in the coolant may be misunderstood as a motor abnormal, thereby shutting down the system.

US 2022/376277 A1 discloses a temperature control apparatus and method for fuel cell system, where the apparatus includes a fuel cell stack, a first pump disposed on a first cooling line, a first radiator disposed on the first cooling line, power electronic parts, a second pump disposed on a second cooling line, a second radiator disposed on the second cooling line, a cooling fan configured to blow exterior air to any one of the first radiator and the second radiator, and a controller configured to determine an RPM of the cooling fan based on a coolant temperature at an inlet of the fuel cell stack and a first exterior air temperature, to determine a target cooling performance of the plurality of power electronic parts based on power consumptions of the plurality of power electronic parts, and to determine an RPM of the second pump based on the target cooling performance of the plurality of power electronic parts, the RPM of the cooling fan, and a second exterior air temperature.

US 2022/367888 A1 discloses an apparatus for controlling driving of a stack cooling pump of a fuel cell system. The apparatus includes a cooling unit having a fuel cell stack installed in a fuel cell vehicle and a cooling pump configured to move a coolant. A reservoir allows the coolant moving toward the cooling pump to be injected thereinto. A controller is configured to sequentially operate the cooling pump in a predetermined pre-run mode and a predetermined air bubble removal mode when the coolant is injected into the reservoir.

US 2016/242326 A1 discloses a cooling system which includes, for instance, a coolant circulation loop, one or more primary coolant pumps, and a fill and drain pump. The primary coolant pump(s) is coupled to facilitate circulating coolant through the coolant circulation loop, and the fill and drain pump facilitates selective filling of the cooling system with the coolant, or draining of the coolant from the cooling system. The fill and drain pump is integrated with the cooling system as a backup coolant pump to the primary coolant pump(s), and circulates the coolant through the coolant circulation loop responsive to an error in the primary coolant pump(s). The primary coolant pump(s) and fill and drain pumps may be different types of pumps, and the cooling system further includes a control system for automatically activating the fill and drain pump upon detection of an error in the primary coolant pump(s).

### SUMMARY

The invention provides a fuel cell system according to claim 1 and an air bleeding method according to claim 11. Further embodiments are described in the dependent claims.

The motor and the four switching devices may embody a full-bridge circuit to bi-directionally control a rotating operation of the motor.

The method may include terminating the circulation responsive to determining whether a motor of the coolant pump as being in an abnormal state when the current of the coolant pump fails to follow the target duty, while the target duty of the coolant pump is controlled through the sine wave in the range of 0 % to 100 %.

The method may include controlling the target duty of the coolant pump to operate at a fixed value for one cycle to determine the change of the current of the coolant pump when the air bubbles are generated, determining that the air bubbles have been removed from the electronic part cooling line responsive to the current of the coolant pump following the target duty having the fixed value for the one cycle, and determining that the air bubbles have not been removed from the electronic part cooling line responsive to the current of the coolant pump failing to follow the target duty having the fixed value for the one cycle.

The performing of the air bleeding may include controlling the target duty of the coolant pump to the fixed value, for the one cycle and determining the current change of the coolant pump and performing air bleeding until the current of the coolant pump follows the target duty having the fixed value.

In a general aspect, here is provided a processor-implemented method including detecting a presence of air bubbles within a coolant system based on a change in a current draw of a coolant pump during a circulation of coolant within the coolant system and initiating an air bleeding process through the coolant pump when the presence of air bubbles is detected.

The method may include monitoring the current draw of the coolant pump while operating the coolant pump at a predefined target duty.

The predefined target duty of the coolant pump may be modulated using a sine wave within a range of 0% to 100% when the change in current draw of the coolant pump exceeds a predefined target duty change.

The method may include configuring the coolant pump to operate at a fixed target duty having a fixed value for a single cycle responsive to the detection of the presence of air bubbles and monitoring if the current draw of the coolant pump follows the fixed target duty for the single cycle to determine whether the air bubbles have been removed from the electronic part cooling line.

### BRIEF DESCRIPTION OF THE DRAWINGS

FIG. 1 is a view illustrating an electronic part cooling line of a fuel cell system, according to an embodiment of the present disclosure;
FIG. 2 is a view illustrating a detailed configuration of a coolant pump, according to an embodiment of the present disclosure;
FIG. 3 is a view illustrating a control structure of a reservoir valve, according to an embodiment of the present disclosure;
FIG. 4 is a view illustrating a control structure of a fuel cell system, according to an embodiment of the present disclosure;
FIGS. 5A, 5B, and 5C are views to describe an operation of determining whether air bubbles are generated in a fuel cell system, according to an embodiment of the present disclosure;
FIGS. 6A and 6B are views to describe an air bleeding operation of a fuel cell system according to an embodiment of the present disclosure; and
FIGS. 7 and 8 are views illustrating an operation flow of an air bleeding method of a fuel cell system, according to an embodiment of the present disclosure.

Throughout the drawings and the detailed description, unless otherwise described or provided, the same, or like, drawing reference numerals may be understood to refer to the same, or like, elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Advantages and features of the present disclosure and methods of achieving the advantages and features will be clear with reference to embodiments described in detail below together with the accompanying drawings. However, the present disclosure is not limited to the embodiments disclosed herein but will be implemented in various forms. The embodiments of the present disclosure are provided so that the present disclosure is completely disclosed, and a person with ordinary skill in the art can fully understand the scope of the present disclosure. The present disclosure will be defined only by the scope of the appended claims. Meanwhile, the terms used in the present specification are for explaining the embodiments, not for limiting the present disclosure.

Terms, such as first, second, A, B, (a), (b) or the like, may be used herein to describe components. Each of these terminologies is not used to define an essence, order or sequence of a corresponding component but used merely to distinguish the corresponding component from other component(s). For example, a first component may be referred to as a second component, and similarly the second component may also be referred to as the first component.

Throughout the specification, when a component is described as being "connected to," or "coupled to" another component, it may be directly "connected to," or "coupled to" the other component, or there may be one or more other components intervening therebetween. In contrast, when an element is described as being "directly connected to," or "directly coupled to" another element, there can be no other elements intervening therebetween.

In a description of the embodiment, in a case in which any one element is described as being formed on or under another element, such a description includes both a case in which the two elements are formed in direct contact with each other and a case in which the two elements are in indirect contact with each other with one or more other elements interposed between the two elements. In addition, when one element is described as being formed on or under another element, such a description may include a case in which the one element is formed at an upper side or a lower side with respect to another element.

The singular forms "a", "an", and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

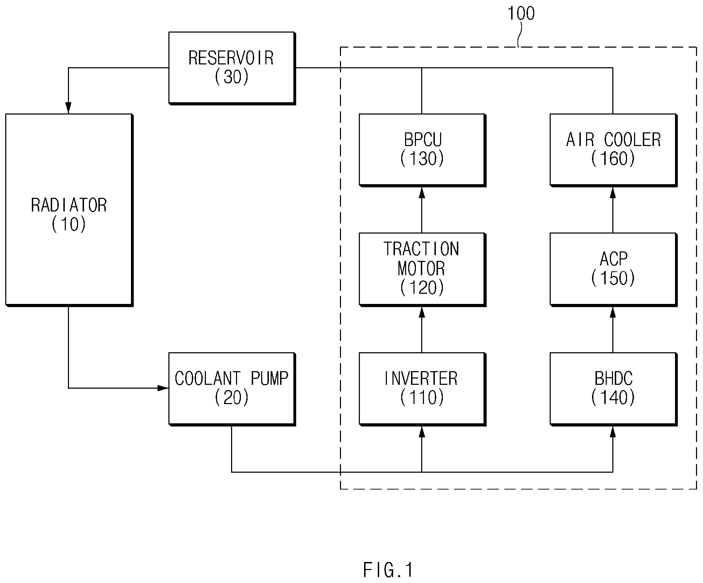

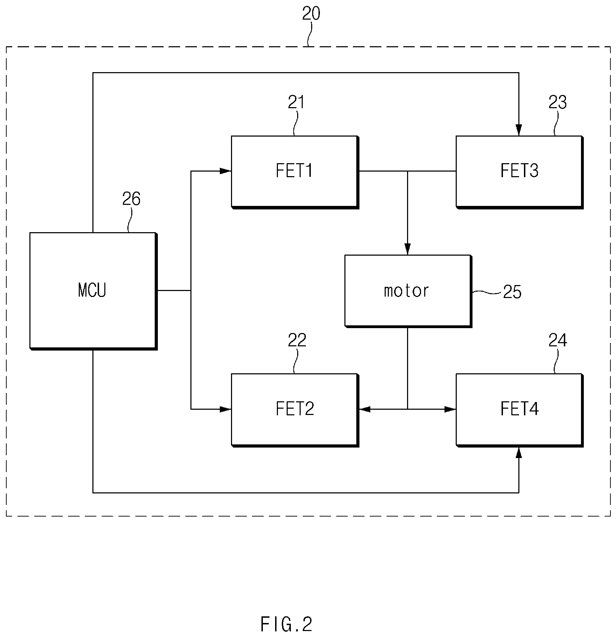

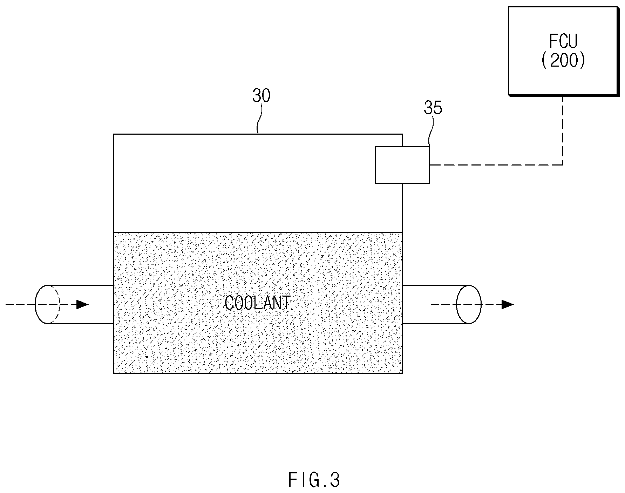

FIG. 1 is a view illustrating an electronic part cooling line of a fuel cell system, according to an embodiment of the present disclosure; FIG. 2 is a view illustrating a detailed configuration of a coolant pump, according to an embodiment of the present disclosure; and FIG. 3 is a view illustrating a control structure of a reservoir valve, according to an embodiment of the present disclosure.

The fuel cell system according to an embodiment of the present disclosure may be applied to a small moving object. For example, a fuel cell applied to the fuel cell system according to an embodiment of the present disclosure may include Polymer Electrolyte Membrane Fuel Cell (PEMFC).

The fuel cell system may include a stack cooling line to circulate a stack coolant passing through the fuel cell stack, and an electronic part cooling line to circulate an electronic part coolant passing through the power electronic parts (PE). According to an embodiment, the fuel cell system may further include a heat exchanger to exchange heat between the stack coolant and the electronic part coolant, but the heat exchanger may be omitted.

A fuel cell stack, a heater, a stack coolant pump, an ion filter, and a stack radiator may be provided on the stack cooling line of the fuel cell system, and a stack reservoir to store the stack coolant may be connected to the stack radiator.

In addition, electronic parts, the electronic part radiator, and an electronic part coolant pump may be disposed on the electronic part cooling line of the fuel cell system, and an electric reservoir to store electronic part coolant may be connected to the electronic part radiator.

Accordingly, the present disclosure relates to the electronic part cooling line of the fuel cell system. The following embodiment will be described while focusing on the configuration and the operation of the fuel cell system when viewed based on the electronic part cooling line.

Referring to FIG. 1, the electronic part cooling line of the fuel cell system is configured to pass through the electronic part 100, and the coolant may circulate along the electronic part cooling line. In this case, the electronic part 100 may be understood as a component which uses the power of the moving object as an energy source, and the present disclosure is not limited in the type and number of electronic parts 100.

For example, the electronic part 100 may include an inverter 110 to change a direct current (DC) voltage to an alternating current (AC) voltage to be supplied to the motor, a traction motor 120 to transmit mechanical driving force to a driving mechanism of a moving object using the power supplied by the inverter 110, a blower pump control unit (BPCU) 130 to control a blower (not illustrated), which supplies external air for driving the fuel cell stack, a bi-directional high voltage DC-DC converter 140 (BHDC) interposed between the fuel cell stack (not illustrated) and a high voltage battery (not illustrated), an air compressor (ACP) 150 which compresses the air supplied to the fuel cell stack, and an air cooler 160

Although not illustrated in FIG. 1, the electronic part 100 may further include a low-voltage DC-DC converter (LDC) and a DC-DC buck/boost converter which convert a DC high voltage, which is supplied from the high voltage battery, into a DC low voltage.

The electronic part radiator (hereinafter, referred to as a "radiator") 10 may be disposed on the electronic part cooling line to cool the coolant circulating the electronic part 100. The radiator 10 may be formed in various structures to cool the coolant, and the type and structure of the radiator 10 are not limited thereto.

According to an embodiment, the radiator 10 may be configured to be cooled simultaneously by one cooling fan, such as a stack radiator (not illustrated). For example, the radiator 10 and the stack radiator are arranged side by side, and the cooling fan may be set to blow the external air to the radiator 10 and the stack radiator.

According to another embodiment, a cooling fan for cooling the radiator 10 and a cooling fan for cooling the stack radiator may be separately disposed.

In addition, a coolant PE pump (CPP) (hereinafter, referred to as a "coolant pump") 20 may be disposed on the electronic part cooling line to forcibly flow the coolant. The coolant pump 20 may include a pumping unit which pumps the coolant to the electronic part 100, and the type and the characteristic of the coolant pump 20 are limited thereto.

Referring to FIG. 2, the coolant pump 20 may include a motor 25 for pump driving and four switching devices connected to the motor 25. For example, the switching device may be a field effect transistor (FET). In this case, the four FETs 21 to 24 may constitute a full bridge circuit based on the motor 25.

In addition, the coolant pump 20 may further include a controller (MCU) 26 which controls the operations of four FETs 21 to 24 which constitute the full bridge circuit. The controller 26 controls the rotating operation of the motor 25 by opening or closing gates of the four FETs 21 to 24.

When the motor 25 is controlled, the controller 26 may control the forward/reverse direction and a rotation speed (RPM) of the motor 25. In this case, the controller 26 may bi-directionally control the rotation direction of the motor 25 through the first FET to the fourth FET 21 to 24.

For example, the controller 26 may control gates connected to the first FET 21 and the fourth FET 24 to be open, and gates connected to the second FET 22 and the third FET 23 to be closed. In this case, as the current flows to the first FET 21 and the fourth FET 24, the motor 25 rotates in the first direction.

For another example, the controller 26 may control the gates connected to first FET 21 and the fourth FET 24 to be closed, and the gates connected to the second FET 22 and the third FET 23 to be open. In this case, the current flows to the second FET 22 and the third FET 23, and the motor 25 rotates in the second direction, which is opposite to the first direction.

In this case, the coolant pump 20 controls a rotation speed and direction of the motor 25 in response to a control signal from the controller 200. For example, the coolant pump 20 may perform air bleeding by controlling the rotation speed and direction of the motor 25 based on the control signal from the controller 200 when air bubbles are determined as being generated in the coolant.

In addition, the electronic part reservoir 30 (hereinafter, briefly referred to as a "reservoir") connected to the radiator 10 may be disposed on the electronic part cooling line. The reservoir 30, which is a coolant storage tank in which coolant is stored, may store coolant flowing out of the radiator 10 at higher pressure and may supply the coolant stored in the coolant storage tank back to the radiator 10 at lower pressure.

Referring to FIG. 3, the reservoir 30 stores the coolant introduced through an inlet and supplies the coolant stored in the coolant storage tank through an outlet to the radiator 10 when the coolant is insufficient.

The reservoir 30 may be equipped with a reservoir valve 35 to discharge air bubbles (air) generated on the electronic part cooling line during air bleeding. The reservoir valve 35 may be closed when the electronic part 100 of the electronic part cooling line is cooled, and may be opened only during the air bleeding. The opening/closing operation of the reservoir valve 35 may be controlled by the controller 200. In this case, the shape, structure, and installation position of the reservoir valve 35 installed in the reservoir 30 may vary depending on required conditions and design specifications, and the present disclosure is not limited thereto. Preferably, the reservoir valve 35 may be installed at a position higher than the upper limit height of the coolant stored in the reservoir 30.

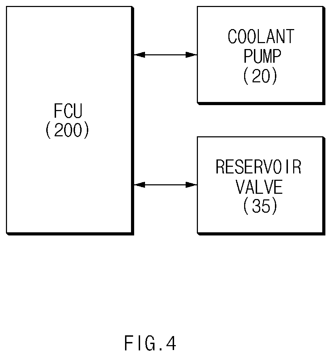

FIG. 4 is a view illustrating a control structure of a fuel cell system, according to an embodiment of the present disclosure. Referring to FIG. 4, the fuel cell system may include the controller 200 which controls the operation of the coolant pump 20 and the reservoir valve 35.

The controller 200 may be a hardware device such as a processor or a central processing unit (CPU), or a program implemented by a processor. The controller 200 may be connected to each component of the fuel cell system to perform an overall function of the fuel cell system. For example, the controller 200 may be a fuel cell control unit (FCU), which is an upper controller.

The controller 200 controls the operation of the electronic part 100 when the fuel cell system is turned on, controls the operation of the radiator 10, the coolant pump 20, and the reservoir 30 while the electronic part 100 is operating, and allows the coolant to circulate along the electronic part cooling line.

The controller 200 may determine whether air bubbles are generated in the coolant while the coolant circulates along the electronic part cooling line.

To this end, the controller 200 controls the coolant pump 20 based on the target duty and monitors the current signal of the coolant pump 20. In this case, the controller 200 may continue to monitor a current signal of the coolant pump 20 when the change of a current of the coolant pump 20 is less than or equal to a target duty change of the coolant pump 20. Meanwhile, when the current change of the coolant pump 20 exceeds the target duty change of the coolant pump 20, the controller 200 controls the target duty of the coolant pump 20 through a sine wave in the range of 0 % to 100 %.

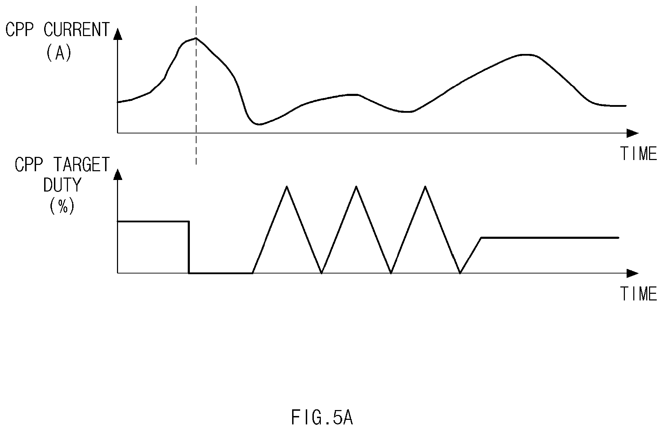

In this case, the controller may determine whether air bubbles are generated depending on whether the current of the coolant pump 20 follows the target duty. The operation of determining whether air bubbles are generated will be described with reference to the embodiments of FIGS. 5A to 5C.

First, FIG. 5A illustrates an embodiment in which the current of the coolant pump 20 does not follow the target duty of the coolant pump 20 when the target duty of the coolant pump 20 is controlled through the sine wave in the range of 0 % to 100 %.

As illustrated in FIG. 5A, when the current of the coolant pump 20 does not follow the target duty of the coolant pump 20, the controller 200 may determine the motor 25 of the coolant pump 20 as being abnormal. In this case, the controller 200 notifies the abnormal state of the motor 25 of the coolant pump 20 and shuts down the fuel cell system. In this case, the controller 200 may induce the fuel cell system to shut down after requesting an emergency stop to the mobile controller 200 to prevent a dangerous accident from occurring.

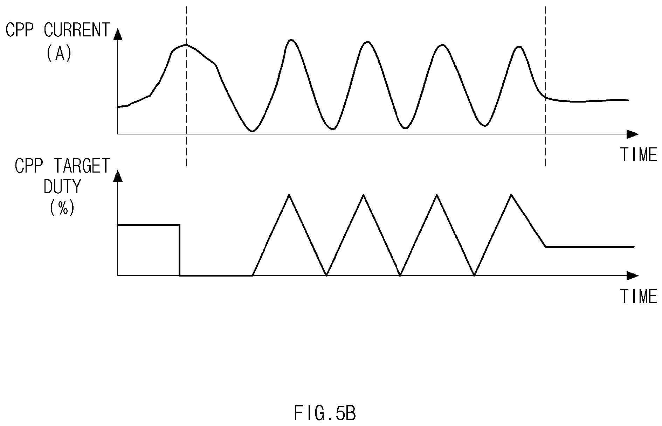

Meanwhile, FIG. 5B illustrates an embodiment in which the current of the coolant pump 20 follows the target duty of the coolant pump 20 when the target duty of the coolant pump 20 is controlled using a sine wave in the range of 0 % to 100 %.

As illustrated in FIG. 5B, when the current of the coolant pump 20 follows the target duty of the coolant pump 20, the controller 200 may determine the air bubbles as being generated in the coolant. In this case, the air bubbles generated on the electronic part cooling line may be removed while the coolant circulates through the electronic part cooling line. Accordingly, the controller 200 controls the target duty of the coolant pump 20 to a fixed value for one cycle. In this case, the controller 200 determines whether the current of the coolant pump 20 follows the target duty.

In this case, when the current of the coolant pump 20 follows the fixed target duty for one cycle, the controller 200 may determine the air bubbles generated on the electronic part cooling as being removed.

Meanwhile, the controller 200 determines air bleeding as being necessary when the current of the coolant pump 20 does not follow the fixed target duty for one cycle.

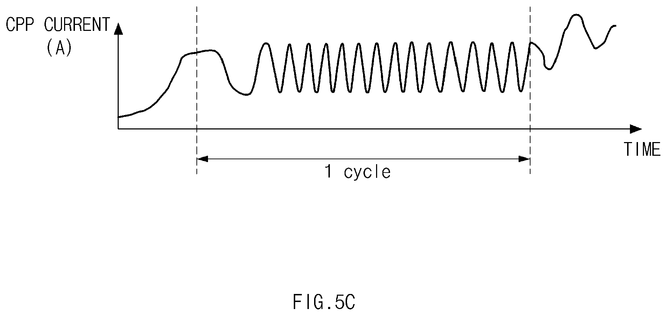

FIG. 5C illustrates that the current of the coolant pump 20 is shaken when the target duty is controlled to a fixed value, even though the current of the coolant pump 20 follows the target duty of the coolant pump 20, according to an embodiment.

As described in FIG. 5C, when the current of the coolant pump 20 does not follow the fixed target duty for one cycle, the controller 200 induces the termination of the fuel cell system for air bleeding and performs air bleeding during the termination cycle of the fuel cell system.

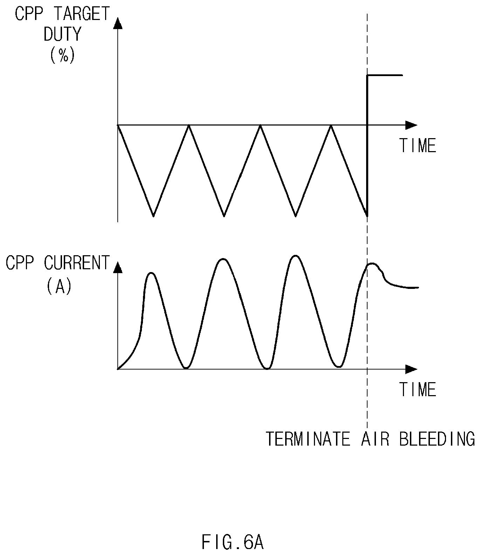

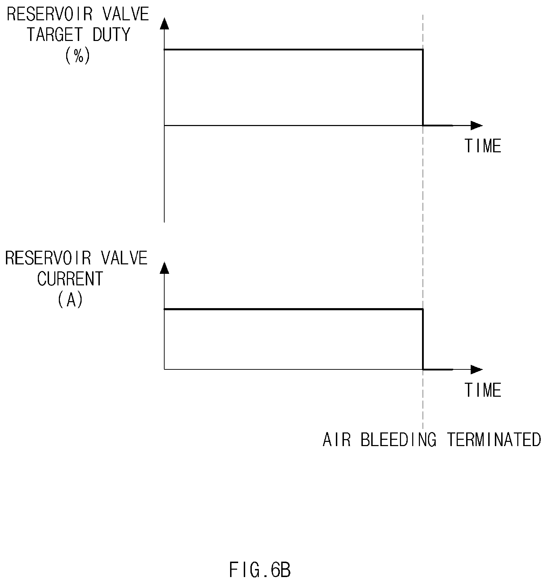

FIG. 6A illustrates the target duty and a current of the coolant pump 20 during one cycle during air bleeding, and FIG. 6B illustrates the target duty and the current of the reservoir valve 35 during the air bleeding.

As illustrated in FIGS 6A and 6B, the controller 200 controls the target duty of the coolant pump 20 using negative (-) sine waves during air bleeding, and controls the target duty of the reservoir valve 35 to 100 % such that the reservoir valve 35 is open.

In this case, the controller 200 may continue to perform air bleeding until the current of the coolant pump 20 follows the fixed target duty for one cycle to remove air bubbles generated in the coolant before the fuel cell system is terminated.

Hereinafter, the operation of the fuel cell system according to the present disclosure configured as described above will be described in more detail.

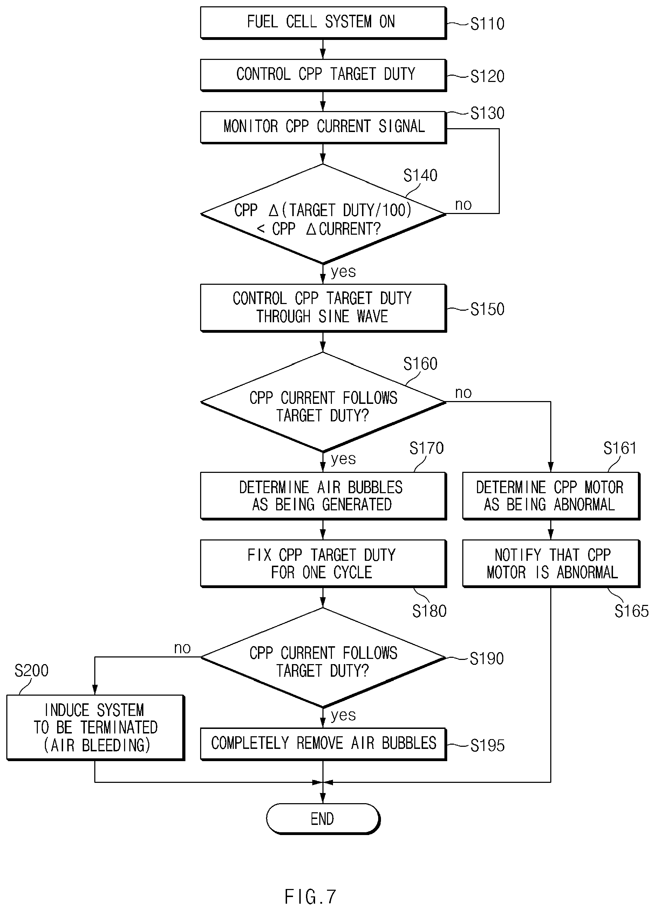

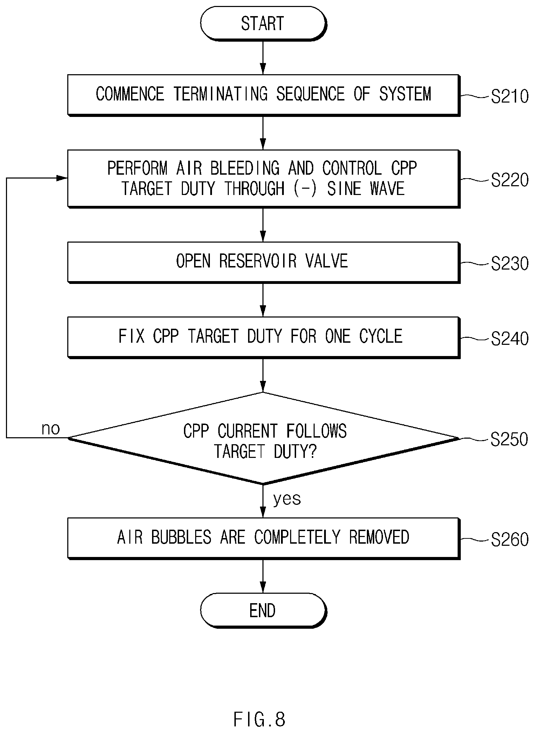

FIGS. 7 and 8 are views illustrating an operation flow of an air bleeding method of a fuel cell system, according to an embodiment of the present disclosure.

Referring to FIG. 7, the fuel cell system controls the coolant pump 20 based on the target duty (S120), when the fuel cell system is turned on (S110). The fuel cell system monitors the current signal of the coolant pump 20, while controlling the coolant pump 20 in the process of 'S120' (S130).

In this case, the fuel cell system may continue to monitor the current signal of the coolant pump 20 (S130), when the current change of the coolant pump 20 is less than or equal to the target duty change of the coolant pump 20 (S140).

Meanwhile, the fuel cell system controls the target duty of the coolant pump 20 through the sine wave in the range of 0 % to 100 % to determine whether air bubbles are generated, when the current change of the coolant pump 20 exceeds the target duty change of the coolant pump 20 (S150).

The fuel cell system determines whether the current of the coolant pump 20 follows the target duty while controlling the target duty of the coolant pump 20 through the sine wave in S150. When the current of the coolant pump 20 does not follow the target duty (S160), the fuel cell system determines the motor 25 of the coolant pump 20 as being abnormal (S161), and notifies the abnormal state of the motor 25 of the coolant pump 20 (S165).

Thereafter, the fuel cell system may shut down the system after requesting an emergency stop to the mobile controller to prevent a dangerous accident from occurring.

Meanwhile, when the current of the coolant pump 20 follows the target duty in 'S160', the fuel cell system determines air bubbles as being generated on the electronic part cooling line (S170). In this case, the fuel cell system controls the target duty of the coolant pump 20 to the fixed value for one cycle (S180).

When determining the current of the coolant pump 20 as following the target duty, which is fixed for one cycle in 'S180' (S190), the fuel cell system may determine air bubbles generated on the electronic part cooling line as completely removed (S195).

Meanwhile, when determining that the current of the coolant pump 20 does not follow the fixed target duty for a cycle in 'S190', the fuel cell system determines that air bleeding is necessary and performs the air bleeding while the system is terminated (S200).

Hereinafter, the operation of performing the air bleeding in the fuel cell system will be described with reference to FIG. 8.

Referring to FIG. 8, when a system terminating sequence is commenced (S210), the fuel cell system performs the air bleeding (S220). In 'S220', the fuel cell system controls the target duty of the coolant pump 20 using (-) sine waves, for air bridging.

In addition, the fuel cell system opens the reservoir valve 35 to discharge air bubbles while performing air bleeding (S230).

In this case, the fuel cell system controls the target duty of the coolant pump 20 to a fixed value for one cycle (S240), and determines whether the current of the coolant pump 20 follows the fixed target duty for one cycle.

When the current of the coolant pump 20 does not follow the fixed target duty for one cycle (S250), the fuel cell system iterates 'S220' to 'S250' processes until the current of the coolant pump 20 follows the fixed target duty for one cycle.

Meanwhile, when the current of the coolant pump 20 follows the fixed target duty for one cycle in S250, the fuel cell system determines that the air bubbles are completely removed (S260), and is terminated.

As described above, according to an embodiment of the present disclosure, the fuel cell system and the air bleeding method thereof, the air bleeding performance may be improved by removing air bubbles generated on the electronic part cooling line, when the electronic part coolant pump (EWP) is not installed in the electronic part cooling line. The air bubbles in the coolant may be easily discharged to the outside, when performing air bleeding in the electronic part coolant pump by adding the bleeding valve to the reservoir valve. In addition, according to an embodiment the present disclosure, it is possible to prevent unnecessary work to identify the cause of the abnormality by determining and coping with the occurrence of air bubbles on the electronic part cooling line.

According to an embodiment of the present disclosure, the electronic part cooling performance may be improved by removing air bubbles from coolant by self-performing air bleeding on the electronic part coolant pump, when the electric water pump (EWP) is not installed on the electronic part cooling line.

In addition, according to an embodiment of the present disclosure, the air bubbles in the coolant may be easily discharged to the outside, when the air bleeding is performed in the electronic part coolant pump, by adding the air bleeding valve to the reservoir tank.

In addition, according to an embodiment of the present disclosure, whether the air bubbles are generated on the electronic part cooling line may be determined, and the air bubbles may be dealt with to prevent the unnecessary work for determining the cause of the abnormality.

Various embodiments of the present disclosure do not list all available combinations but are for describing a representative aspect of the present disclosure, and descriptions of various embodiments may be applied independently or may be applied through a combination of two or more.

A number of embodiments have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

## Claims

1. A fuel cell system, comprising:
a radiator (10) disposed on an electronic part cooling line, the cooling line configured to pass through an electronic part (100) and to circulate a coolant, the radiator (10) being configured to cool the coolant;
a coolant pump (20) configured to pump the coolant to circulate the coolant in electronic part cooling line; and
a controller (200) configured to:
determine whether air bubbles are generated, based on a change in a current of the coolant pump (20) while the coolant is circulating; and
control an air bleeding through the coolant pump (20),
wherein the controller (200) is further configured to:
monitor the current of the coolant pump (20) while controlling the coolant pump (20) to a target duty,
control the target duty of the coolant pump (20) through a sine wave in a range of 0 % to 100 %, when the change in the current of the coolant pump (20) exceeds a target duty change,
determine whether the air bubbles are being generated in the electronic part cooling line, when the current of the coolant pump (20) follows the target duty, and
output a control signal for the air bleeding to the coolant pump (20).

2. The fuel cell system of claim 1, wherein the controller (200) is further configured to:
determine whether a motor (25) of the coolant pump (20) is operating in an abnormal manner when the current of the coolant pump (20) fails to follow the target duty, while the target duty of the coolant pump (20) is controlled through the sine wave in the range of 0 % to 100 %; and
terminate an operation of the fuel cell system responsive to a determination of the abnormal manner.

3. The fuel cell system of claim 1, wherein the controller (200) is further configured to:
control the target duty of the coolant pump (20) to a fixed value for one cycle to determine the change of the current of the coolant pump (20), responsive to a determination that the air bubbles are being generated in the electronic part cooling line.

4. The fuel cell system of claim 3, wherein the controller (200) is further configured to:
determine whether the air bubbles are being removed from the electronic part cooling line, when the current of the coolant pump (20) follows the target duty having the fixed value for one cycle.

5. The fuel cell system of claim 3 or 4, wherein the controller (200) is further configured to:
perform the air bleeding by determining whether the air bubbles are not being removed from the electronic part cooling line, when the current of the coolant pump (20) fails to follow the target duty having the fixed value for the one cycle.

6. The fuel cell system of claim 5, wherein the controller (200) is further configured to:
control the target duty of the coolant pump (20) through a (-) sine wave; and
perform the air bleeding responsive to a terminating sequence of the fuel cell system being commenced.

7. The fuel cell system of claim 6, wherein the controller (200) is further configured to:
control the target duty of the coolant pump (20) to the fixed value for the one cycle;
determine the change of the current of the coolant pump (20); and
perform the air bleeding until the current of the coolant pump (20) follows the target duty having the fixed value.

8. The fuel cell system of any one of claims 1 to 7, further comprising:
a reservoir (30) installed on the electronic part cooling line and connected to the radiator (10), the reservoir (30) being configured to store the coolant.

9. The fuel cell system of claim 8, wherein the reservoir (30) includes:
a reservoir valve (35) open to discharge air when the air bleeding is performed.

10. The fuel cell system of any one of claims 1 to 9, wherein the coolant pump (20) includes:
a motor (25); and
four switching devices (21, 22, 23, 24), and
wherein the motor (25) and the four switching devices (21, 22, 23, 24) comprise a full-bridge circuit to bi-directionally control a rotating operation of the motor (25).

11. An air bleeding method, the method comprising:
circulating a coolant, which is cooled by a radiator (10), along an electronic part cooling line passing through an electronic part (100);
determining whether air bubbles are generated, based on change in a current of a coolant pump (20) while the coolant is circulating along the electronic part cooling line; and
controlling an air bleeding through the coolant pump (20), when the air bubbles are generated,
wherein the determining of whether the air bubbles are generated includes:
monitoring (S130) the current of the coolant pump while controlling the coolant pump to a target duty;
controlling (S150) the target duty of the coolant pump through a sine wave in a range of 0 % to 100 %, when the current change of the coolant pump exceeds a target duty change; and
determining (S170) the bubbles as being generated on the electronic part cooling line, when the current of the coolant pump follows the target duty.

12. The air bleeding method of claim 11, wherein the controlling of the air bleeding includes:
performing (S210) a terminating sequence of a system, responsive to a determination that the air bubbles are not removed from the electronic part cooling line, wherein the terminating sequence comprises:
performing (S220) the air bleeding by controlling a target duty of the coolant pump (20) through a (-) sine wave; and
opening (S230) a reservoir valve (35) mounted on the electronic part cooling line to discharge air from a reservoir (30) to store the coolant during the air bleeding.

## Patentansprüche

1. Brennstoffzellensystem, welches aufweist:
einen Radiator (10), der an einer Elektronikteil-Kühlleitung angeordnet ist, wobei die Kühlleitung eingerichtet ist, um durch ein Elektronikteil (100) hindurchzugehen und um ein Kühlmittel zu zirkulieren, wobei der Radiator (10) eingerichtet ist, um das Kühlmittel zu kühlen;
eine Kühlmittelpumpe (20), die eingerichtet ist, um das Kühlmittel zu pumpen, um das Kühlmittel in der Elektronikteil-Kühlleitung zu zirkulieren; und
eine Steuerungsvorrichtung (200), die eingerichtet ist, um:
zu ermitteln, ob Luftblasen erzeugt werden, basierend auf einer Änderung in einem Strom der Kühlmittelpumpe (20), während das Kühlmittel zirkuliert; und
ein Entlüften durch die Kühlmittelpumpe (20) zu steuern,
wobei die Steuerungsvorrichtung (200) ferner eingerichtet ist, um:
den Strom der Kühlmittelpumpe (20) zu überwachen, während die Kühlmittelpumpe (20) auf ein Ziel-Ansteuerverhältnis gesteuert wird,
das Ziel-Ansteuerverhältnis der Kühlmittelpumpe (20) durch eine Sinus-Welle in einem Bereich von 0 % bis 100 % zu steuern, wenn die Änderung in dem Strom der Kühlmittelpumpe (20) eine Ziel-Ansteuerverhältnis-Änderung übersteigt,
zu ermitteln, ob die Luftblasen in der Elektronikteil-Kühlleitung erzeugt werden, wenn der Strom der Kühlmittelpumpe (20) dem Ziel-Ansteuerverhältnis folgt, und
ein Steuerungssignal für das Entlüften an die Kühlmittelpumpe (20) auszugeben.

2. Brennstoffzellensystem gemäß Anspruch 1, wobei die Steuerungsvorrichtung (200) ferner eingerichtet ist, um:
zu ermitteln, ob ein Motor (25) der Kühlmittelpumpe (20) in einer anormalen Weise arbeitet, wenn der Strom der Kühlmittelpumpe (20) scheitert, dem Ziel-Ansteuerverhältnis zu folgen, während das Ziel-Ansteuerverhältnis der Kühlmittelpumpe (20) durch die Sinus-Welle in dem Bereich von 0 % bis 100 % gesteuert wird; und
einen Betrieb des Brennstoffzellensystems als Reaktion auf eine Ermittlung der anormalen Weise zu beenden.

3. Brennstoffzellensystem gemäß Anspruch 1, wobei die Steuerungsvorrichtung (200) ferner eingerichtet ist, um:
das Ziel-Ansteuerverhältnis der Kühlmittelpumpe (20) auf einen festen Wert für einen Zyklus zu steuern, um die Änderung des Stroms der Kühlmittelpumpe (20) zu ermitteln, als Reaktion auf eine Ermittlung, dass die Luftblasen in der Elektronikteil-Kühlleitung erzeugt werden.

4. Brennstoffzellensystem gemäß Anspruch 3, wobei die Steuerungsvorrichtung (200) ferner eingerichtet ist, um:
zu ermitteln, ob die Luftblasen aus der Elektronikteil-Kühlleitung entfernt werden, wenn der Strom der Kühlmittelpumpe (20) dem Ziel-Ansteuerverhältnis, welches den festen Wert für einen Zyklus hat, folgt.

5. Brennstoffzellensystem gemäß Anspruch 3 oder 4, wobei die Steuerungsvorrichtung (200) ferner eingerichtet ist, um:
das Entlüften durchzuführen durch Ermitteln, ob die Luftblasen nicht aus der Elektronikteil-Kühlleitung entfernt werden, wenn der Strom der Kühlmittelpumpe (20) scheitert, dem Ziel-Ansteuerverhältnis, welches den festen Wert für den einen Zyklus hat, zu folgen.

6. Brennstoffzellensystem gemäß Anspruch 5, wobei die Steuerungsvorrichtung (200) ferner eingerichtet ist, um:
das Ziel-Ansteuerverhältnis der Kühlmittelpumpe (20) durch eine (-) Sinus-Welle zu steuern; und
das Entlüften als Reaktion darauf, dass eine Beendigungssequenz des Brennstoffzellensystems begonnen wird, durchzuführen.

7. Brennstoffzellensystem gemäß Anspruch 6, wobei die Steuerungsvorrichtung (200) ferner eingerichtet ist, um:
das Ziel-Ansteuerverhältnis der Kühlmittelpumpe (20) auf den festen Wert für den einen Zyklus zu steuern;
die Änderung des Stroms der Kühlmittelpumpe (20) zu ermitteln; und
das Entlüften durchzuführen, bis der Strom der Kühlmittelpumpe (20) dem Ziel-Ansteuerverhältnis, welches den festen Wert hat, folgt.

8. Brennstoffzellensystem gemäß irgendeinem der Ansprüche 1 bis 7, welches ferner aufweist:
einen Behälter (30), der an der Elektronikteil-Kühlleitung installiert ist und der mit dem Radiator (10) verbunden ist, wobei der Behälter (30) eingerichtet ist, um das Kühlmittel zu speichern.

9. Brennstoffzellensystem gemäß Anspruch 8, wobei der Behälter (30) aufweist:
ein Behälter-Ventil (35), das offen ist, um Luft auszugeben, wenn das Entlüften durchgeführt wird.

10. Brennstoffzellensystem gemäß irgendeinem der Ansprüche 1 bis 9, wobei die Kühlmittelpumpe (20) aufweist:
einen Motor (25); und
vier Schaltvorrichtungen (21, 22, 23, 24), und
wobei der Motor (25) und die vier Schaltvorrichtungen (21, 22, 23, 24) einen Vollbrücke-Schaltkreis aufweisen, um einen Drehbetrieb des Motors (25) bidirektional zu steuern.

11. Entlüften-Verfahren, wobei das Verfahren aufweist:
Zirkulieren eines Kühlmittels, das mittels eines Radiators (10) gekühlt wird, entlang einer Elektronikteil-Kühlleitung, die durch ein Elektronikteil (100) hindurchgeht;
Ermitteln, ob Luftblasen erzeugt werden, basierend auf einer Änderung in einem Strom einer Kühlmittelpumpe (20), während das Kühlmittel entlang der Elektronikteil-Kühlleitung zirkuliert; und
Steuern eines Entlüftens durch die Kühlmittelpumpe (20), wenn die Luftblasen erzeugt werden,
wobei das Ermitteln davon, ob die Luftblasen erzeugt werden, aufweist:
Überwachen (S130) des Stroms der Kühlmittelpumpe, während die Kühlmittelpumpe auf ein Ziel-Ansteuerverhältnis gesteuert wird;
Steuern (S150) des Ziel-Ansteuerverhältnisses der Kühlmittelpumpe durch eine Sinus-Welle in einem Bereich von 0 % bis 100 %, wenn die Stromänderung der Kühlmittelpumpe eine Ziel-Ansteuerverhältnis-Änderung übersteigt; und
Ermitteln (S170), dass die Blasen in der Elektronikteil-Kühlleitung erzeugt werden, wenn der Strom der Kühlmittelpumpe dem Ziel-Ansteuerverhältnis folgt.

12. Entlüften-Verfahren gemäß Anspruch 11, wobei das Steuern des Entlüftens aufweist:
Durchführen (S210) einer Beendigungssequenz eines Systems, als Reaktion auf eine Ermittlung, dass die Luftblasen nicht aus der Elektronikteil-Kühlleitung entfernt werden, wobei die Beendigungssequenz aufweist:
Durchführen (S220) des Entlüftens durch Steuern eines Ziel-Ansteuerverhältnisses der Kühlmittelpumpe (20) durch eine (-) Sinus-Welle; und
Öffnen (S230) eines Behälter-Ventils (35), das an der Elektronikteil-Kühlleitung montiert ist, um Luft aus einem Behälter (30) auszugeben, um das Kühlmittel während des Entlüftens zu speichern.

## Revendications

1. Système de pile à combustible, comprenant :
un radiateur (10) disposé sur une conduite de refroidissement de composant électronique, la conduite de refroidissement étant configurée pour passer à travers un composant électronique (100) et pour faire circuler un liquide de refroidissement, le radiateur (10) étant configuré pour refroidir le liquide de refroidissement ;
une pompe de liquide de refroidissement (20) configurée pour pomper le liquide de refroidissement afin de faire circuler le liquide de refroidissement dans la conduite de refroidissement de composant électronique ; et
un contrôleur (200) configuré pour :
déterminer si des bulles d'air sont générées, sur la base d'une variation d'un courant de la pompe de liquide de refroidissement (20) pendant que le liquide de refroidissement circule ; et
commander une purge d'air moyennant la pompe de liquide de refroidissement (20),
dans lequel le contrôleur (200) est en outre configuré pour :
surveiller le courant de la pompe de liquide de refroidissement (20) tout en commandant la pompe de liquide de refroidissement (20) à un rapport de service cible,
commander le rapport de service cible de la pompe de liquide de refroidissement (20) moyennant une onde sinusoïdale dans une plage de 0 % à 100 %, lorsque la variation du courant de la pompe de refroidissement (20) dépasse une variation de rapport de service cible,
déterminer si des bulles d'air sont générées dans la conduite de refroidissement de composant électronique, lorsque le courant de la pompe de refroidissement (20) suit le rapport de service cible, et
émettre un signal de commande pour la purge d'air vers la pompe de refroidissement (20).

2. Système de pile à combustible selon la revendication 1, dans lequel le contrôleur (200) est en outre configuré pour :
déterminer si un moteur (25) de la pompe de refroidissement (20) fonctionne de manière anormale lorsque le courant de la pompe de refroidissement (20) ne parvient pas à suivre le rapport de service cible, alors que le rapport de service cible de la pompe de refroidissement (20) est commandé par l'onde sinusoïdale dans la plage de 0 % à 100 % ; et
terminer un fonctionnement du système de pile à combustible en réponse à une détermination du fonctionnement anormal.

3. Système de pile à combustible selon la revendication 1, dans lequel le contrôleur (200) est en outre configuré pour :
commander le rapport de service cible de la pompe de refroidissement (20) à une valeur fixe pour un cycle afin de déterminer la variation du courant de la pompe de refroidissement (20), en réponse à une détermination selon laquelle les bulles d'air sont générées dans la conduite de refroidissement de composant électronique.

4. Système de pile à combustible selon la revendication 3, dans lequel le contrôleur (200) est en outre configuré pour :
déterminer si les bulles d'air sont éliminées de la conduite de refroidissement de composant électronique, lorsque le courant de la pompe de refroidissement (20) suit le rapport de service cible ayant la valeur fixe pour un cycle.

5. Système de pile à combustible selon la revendication 3 ou 4, dans lequel le contrôleur (200) est en outre configuré pour :
effectuer la purge d'air en déterminant si les bulles d'air ne sont pas éliminées de la conduite de refroidissement de composant électronique, lorsque le courant de la pompe de refroidissement (20) ne parvient pas à suivre le rapport de service cible ayant la valeur fixe pour ledit un cycle.

6. Système de pile à combustible selon la revendication 5, dans lequel le contrôleur (200) est en outre configuré pour :
commander le rapport de service cible de la pompe de refroidissement (20) moyennant une onde sinusoïdale (-) ; et
effectuer la purge d'air en réponse au lancement d'une séquence de terminaison du système de pile à combustible.

7. Système de pile à combustible selon la revendication 6, dans lequel le contrôleur (200) est en outre configuré pour :
commander le rapport de service cible de la pompe de refroidissement (20) à la valeur fixe pour ledit un cycle ;
déterminer la variation du courant de la pompe de refroidissement (20) ; et
effectuer la purge d'air jusqu'à ce que le courant de la pompe de refroidissement (20) suive le rapport de service cible ayant la valeur fixe.

8. Système de pile à combustible selon l'une quelconque des revendications 1 à 7, comprenant en outre :
un réservoir (30) installé sur la conduite de refroidissement de composant électronique et relié au radiateur (10), le réservoir (30) étant configuré pour stocker le liquide de refroidissement.

9. Système de pile à combustible selon la revendication 8, dans lequel le réservoir (30) comprend :
une vanne de réservoir (35) ouverte pour évacuer de l'air lorsque la purge d'air est effectuée.

10. Système de pile à combustible selon l'une quelconque des revendications 1 à 9, dans lequel la pompe de liquide de refroidissement (20) comprend :
un moteur (25) ; et
quatre dispositifs de commutation (21, 22, 23, 24), et
dans lequel le moteur (25) et les quatre dispositifs de commutation (21, 22, 23, 24) comprennent un circuit en pont complet pour commander de manière bidirectionnelle un fonctionnement en rotation du moteur (25).

11. Procédé de purge d'air, le procédé comprenant :
la circulation d'un liquide de refroidissement, qui est refroidi par un radiateur (10), le long d'une conduite de refroidissement de composant électronique passant à travers un composant électronique (100) ;
la détermination si des bulles d'air sont générées, sur la base d'une variation d'un courant d'une pompe de liquide de refroidissement (20) pendant que le liquide de refroidissement circule le long de la conduite de refroidissement de composant électronique ; et
la commande d'une purge d'air par la pompe de liquide de refroidissement (20), lorsque des bulles d'air sont générées,
dans la détermination si les bulles d'air sont générées comprend :
la surveillance (S130) du courant de la pompe de liquide de refroidissement tout en commandant la pompe de liquide de refroidissement à un rapport de service cible ;
la commande (S150) du rapport de service cible de la pompe de refroidissement moyennant une onde sinusoïdale dans une plage de 0 % à 100 %, lorsque la variation de courant de la pompe de refroidissement dépasse une variation de rapport de service cible ; et
la détermination (S170) des bulles comme étant générées sur la conduite de refroidissement de composant électronique, lorsque le courant de la pompe de refroidissement suit le rapport de service cible.

12. Procédé de purge d'air selon la revendication 11, dans lequel la commande de la purge d'air comprend :
l'exécution (S210) d'une séquence de terminaison d'un système, en réponse à une détermination selon laquelle les bulles d'air ne sont pas éliminées de la conduite de refroidissement de composant électronique, la séquence de terminaison comprenant :
l'exécution (S220) de la purge d'air en commandant un rapport de service cible de la pompe de refroidissement (20) moyennant une onde sinusoïdale (-) ; et
l'ouverture (S230) d'une vanne de réservoir (35) montée sur la conduite de refroidissement de composant électronique afin d'évacuer de l'air d'un réservoir (30) pour stocker le liquide de refroidissement pendant la purge d'air.
